(19) Europäisches Patentamt
European Patent Office
Office européen des brevets

(11) EP 0 674 227 B1

(12) **EUROPEAN PATENT SPECIFICATION**

(45) Date of publication and mention
of the grant of the patent:
**12.06.1996 Bulletin 1996/24**

(51) Int Cl.⁶: **G03F 7/07**, G03C 1/795,
B41N 1/14

(21) Application number: **95200223.6**

(22) Date of filing: **30.01.1995**

(54) **Imaging element and method for making a printing plate according to the silver salt diffusion transfer process**

Bildaufzeichnungselement und Verfahren zur Herstellung einer Druckform nach dem Verfahren der Silbersalz Diffusionsübertragung

Elément formant image et méthode de la fabrication d'une plaque d'impression par le procédé de diffusion-transfert de sel d'argent

(84) Designated Contracting States:
**BE DE FR GB NL**

(30) Priority: **22.03.1994 EP 94200734**

(43) Date of publication of application:
**27.09.1995 Bulletin 1995/39**

(60) Divisional application: **95202749.8**

(73) Proprietor: **AGFA-GEVAERT naamloze vennootschap B-2640 Mortsel (BE)**

(72) Inventors:
• **Van Hunsel, Johan B-2640 Mortsel (BE)**
• **Vaes, Jos B-2640 Mortsel (BE)**

(56) References cited:
EP-A- 0 546 598          WO-A-92/11579
GB-A- 1 454 956          US-A- 3 793 249
US-A- 4 114 535          US-A- 5 165 343
US-A- 5 281 509

• **PRODUCT LICENSING INDEX, December 1971, HAVANT GB pages 29 - 31 ANONYMOUS 'POLYESTERAMIDES OF P-AMINOPHENOLS 9206'**

## Description

### 1. Field of the invention.

The present invention relates to lithographic printing plates obtained according the silver salt diffusion transfer process. More in particular the present invention relates to an improvement of the lithographic properties of such printing plates.

### 2. Background of the invention.

The principles of the silver complex diffusion transfer reversal process, hereinafter called DTR-process, have been described e.g. in US-P 2,352,014 and in the book "Photographic Silver Halide Diffusion Processes" by André Rott and Edith Weyde - The Focal Press - London and New York, (1972).

In the DTR-process non-developed silver halide of an information-wise exposed photographic silver halide emulsion layer material is transformed with a so-called silver halide solvent into soluble silver complex compounds which are allowed to diffuse into an image-receiving element and are reduced therein with a developing agent, generally in the presence of physical development nuclei, to form a silver image having reversed image density values ("DTR-image") with respect to the black silver image obtained in the exposed areas of the photographic material.

A DTR-image bearing material can be used as a planographic printing plate wherein the DTR-silver image areas form the water-repellant ink-receptive areas on a water-receptive ink-repellant background. The DTR-image can be formed in the image-receiving layer of a sheet or web material which is a separate element with respect to the photographic silver halide emulsion material (a so-called two-sheet DTR element) or in the image-receiving layer of a so-called single-support-element, also called mono-sheet element, which contains at least one photographic silver halide emulsion layer integral with an image-receiving layer in waterpermeable relationship therewith. It is the latter mono-sheet version which is preferred for the preparation of offset printing plates by the DTR method. For example the United Kingdom Patent Specification 1,241,661 discloses a method for the production of a planographic printing plate consisting of a sheet material comprising an outer hydrophilic colloid layer on the surface of which there is concentrated a silver image stemming from an underlying exposed silver halide emulsion layer by the silver complex diffusion transfer reversal process. The silver image formed on the surface is suitable for printing images in a lithographic printing process using a dampening liquid.

Commercial lithographic printing plate precursors of the latter type typically contain on a flexible support, e.g. polyester or paper in the order given a base layer serving as an anti-halation layer, a silver halide emulsion layer and a surface layer containing physical development nuclei in which the silver image is formed.

Such lithographic printing plate precursors, also called imaging elements may be camera exposed or they can be exposed by means of a scan exposure e.g. a laser or L.E.D. exposure. The latter offers the advantage that the preparation of the printing plate is simplified in that a paste-up to be used for the exposure of the imaging element can be completely prepared on a computer. This paste-up prepared on the computer is then transferred to an image setter equiped with e.g. laser that takes care of the exposure of the imaging element.

Lithographic printing plates obtained according to the silver salt diffusion transfer are generally limited in printing endurance as compared to the aluminium based printing plates that use a diazo composition or photopolymer composition as the photosensitive coating for making the printing plate. Lithographic printing plates obtained according to the DTR-process are generally used for short run printing jobs where the number of copies is not too important but where ease and speed of production of the printing plates are important.

In such short run printing jobs it is also desirable that the number of copies that have to be disposed of at the beginning of the printing job is kept to a minimum in order to increase the production efficiency of the printing process. Unfortunately, with the DTR-type lithographic printing plates a fairly large number of copies have to be disposed of at the beginning of the printing job due to unequal ink acceptance, hue changes between the copies at start up when color printing is performed, image deformations etc... Furthermore, during start-up a lot of adjustment of the printing machine is needed in order to obtain a satisfactory print copy.

### 3. Summary of the invention.

It is an object of the present invention to provide an imaging element and method for making a printing plate therewith according to the silver salt diffusion transfer process, said printing plate having improved lithographic printing properties in particular a reduced number of copies that have to be disposed of at the start of the printing job.

Further objects of the present invention will become clear from the description hereinafter.

According to the present invention there is provided an imaging element comprising on a support in the order given a photosensitive layer comprising a silver halide emulsion and an image-receiving layer comprising physical development nuclei, characterised in that said support is a polyethylene terephthalate film having a thickness between 0.1mm and 0.35mm and a Young-modulus of at least 4300 N/mm$^2$.

According to the present invention there is further provided a method for making a lithographic printing plate comprising the steps of image-wise exposing an imaging element as defined above and subsequently developing a thus obtained imaging element by an alkaline processing liquid in the presence of developing agent(s) and silver halide solvent(s).

4. Detailed description of the invention.

It has been found that the number of copies at the start of the printing job when using a printing plate obtained according to the DTR-process can be reduced by using as a support of the printing plate a polyethylene terephthalate film having a thickness between 0.1mm and 0.35mm and having a Young-modulus (E-modulus) of at least 4300 N/mm$^2$ and more preferably at least 4500 N/mm$^2$.

The Young-modulus also called E-modulus in connection with the present invention can be measured according to method A of the ANSI-D882-91 standard.

In accordance with the present invention, at least one of the two main directions of orientation of the polyethylene terephthalate film, i.e. the machine direction (longitudinal direction) or the direction perpendicular thereto (transverse direction), should have an E-modulus of at least 4300 N/mm$^2$.

According to the most preferred embodiment of the present invention the polyethylene terephthalate film support is isotropic in the E-modulus i.e. the ratio of E-modulus in longitudinal direction to the transverse direction is between 0.8 and 1.3. The use of an isotropic polyethylene terephthalate film support offers the advantage that when the plate is turned 90° the same printing properties are obtained so that manufacturing of different sizes of the printing plates out of a master roll is simplified.

Such isotropic supports also offer an advantage when the imaging element is to be used in an image-setter for high intensity short time exposure. In this application, several images on one printing plate may be oriented parallel and/or perpendicular to the axis of the printing cylinder in the printing machine. When an isotropic polyethylene terephthalate film support is used it will be much easier to obtain a steady print.

On the other hand, when an anisotropic polyethylene terephthalate film support is used a larger E-modulus can be obtained because a large E-modulus in one direction generally goes to the detriment of the E-modulus in the direction perpendicular thereto. In order to obtain the benefit of an anisotropic polyethylene terephthalate film support, such printing plate should be mounted with its E-modulus of more than 4300 N/mm$^2$ perpendicular to the axis of the printing cylinder of the printing press.

The polyester film in accordance with the present invention is a polyethylene terephthalate film. The polyester film in accordance with the present invention may be uniaxially oriented but is preferably biaxially oriented. The desired E-modulus may be obtained by setting the degree of orientation of the polyester film. Preferably, the degree of orientation is obtained by stretching the polyester film in the longitudinal and/or transverse direction with a factor between 1:2 to 1:4.

The E-modulud may further be influenced by adding substances to the polyester film such as e.g. low molecular weight compounds, voiding agents such as e.g. BaSO$_4$, polypropylene and opacifying agents such as e.g. TiO$_2$.

The polyester film support in accordance with the present invention is preferably coated with a layer improving the adhesion of the hydrophilic layers.

A particularly suitable adhesion improving layer, comprises a copolymer containing water-soluble monomers and water-insoluble monomers in a molar ratio between 1:99 and 20:80. Preferably the water soluble monomer is a monomer having one or more carboxylic acid groups. An example of an especially preferred copolymer for use in said adhesion improving layer is a polymer containing 1% to 10% by weight, more preferably 1% to 5% by weight of itaconic acid. Suitable polymers containing itaconic acid are e.g. copolymers of itaconic acid and vinylidene chloride, copolymers of itaconic acid, vinylidene chloride and vinylacetate, copolymers of itaconic acid, vinylidene chloride and methyl (meth) acrylate, copolymers of itaconic acid and vinyl chloride, copolymers of itaconic acid, vinyl chloride, vinylidene chloride and methyl(meth)acrylate etc... A copolymer of itaconic acid, vinylidene chloride and optionally methyl(meth)acrylate wherein the amount of itaconic acid is between 1% and 5%, the amount of vinylidene chloride is between 70% and 95% and the amount of methyl(meth)acrylate is between 0% and 15%. The adhesion improving layer is preferably free of gelatin.

On top of this adhesion improving layer there may be provided a further intermediate layer containing microparticles having an average diameter of less than 50nm preferably colloidal silica and gelatin preferably in a weight ratio of 1:2 and 2:1.

The photographic silver halide emulsions can be prepared from soluble silver salts and soluble halides according to different methods as described e.g. by P. Glafkides in "Chimie et Physique Photographique", Paul Montel, Paris (1967), by G.F. Duffin in "Photographic Emulsion Chemistry", The Focal Press, London (1966), and by V.L. Zelikman et al in "Making and Coating Photographic Emulsion", The Focal Press, London (1966).

The photographic silver halide emulsions used according to the present invention can be prepared by mixing the halide and silver solutions in partially or fully controlled conditions of temperature, concentrations, sequence of addition, and rates of addition. The silver halide can be precipitated according to the single-jet method or the double-jet method.

The silver halide particles of the photographic emulsions used according to the present invention may have a regular crystalline form such as a cubic or octahedral form or they may have a transition form. They may also have an irregular crystalline form such as a spherical form or a tabular form, or may otherwise have a composite crystal form comprising a mixture of said regular and irregular crystalline forms.

According to the present invention the emulsion or emulsions preferably consist principally of silver chloride while a fraction of silver bromide is present ranging from 1 mole % to 40 mole %. The emulsions preferably belong to the core/shell type well known to those skilled in the art in the sense that substantially all the bromide is concentrated in the core. This core contains preferably 10 to 40 % of the total silver halide precipitated, while the shell consists preferably of 60 to 90 % of the total silver halide precipitated.

The average size of the silver halide grains may range from 0.10 to 0.70 $\mu$m , preferably from 0.25 to 0.45 $\mu$m.

The size distribution of the silver halide particles of the photographic emulsions to be used according to the present invention can be homodisperse or heterodisperse. A homodisperse size distribution is obtained when 95% of the grains have a size that does not deviate more than 30% from the average grain size.

Preferably during the precipitation stage Iridium and/or Rhodium containing compounds or a mixture of both are added. The concentration of these added compounds ranges from $10^{-8}$ to $10^{-3}$ mole per mole of $AgNO_3$, preferably between $10^{-7}$ and $10^{-6}$ mole per mole of $AgNO_3$. This results in the building in in the silver halide crystal lattice of minor amounts of Iridium and/or Rhodium, so-called Iridium and/or Rhodium dopants. As known to those skilled in the art numerous scientific and patent publications disclose the addition of Iridium or Rhodium containing compounds or compounds containing other elements of Group VIII of the Periodic System during emulsion preparation.

The emulsions can be chemically sensitized e.g. by adding sulphur-containing compounds during the chemical ripening stage e.g. allyl isothiocyanate, allyl thiourea, and sodium thiosulphate. Also reducing agents e.g. the tin compounds described in BE-P 493,464 and 568,687, and polyamines such as diethylene triamine or derivatives of aminomethane-sulphonic acid can be used as chemical sensitizers. Other suitable chemical sensitizers are noble metals and noble metal compounds such as gold, platinum, palladium, iridium, ruthenium and rhodium. This method of chemical sensitization has been described in the article of R.KOSLOWSKY, Z. Wiss. Photogr. Photophys. Photochem. 46, 65-72 (1951).

The emulsions of the DTR element can be spectrally sensitized according to the spectral emission of the exposure source for which the DTR element is designed.

Suitable sensitizing dyes for the visible spectral region include methine dyes such as those described by F.M. Hamer in "The Cyanine Dyes and Related Compounds", 1964, John Wiley & Sons. Dyes that can be used for this purpose include cyanine dyes, merocyanine dyes, complex cyanine dyes, complex merocyanine dyes, homopolar cyanine dyes, hemicyanine dyes, styryl dyes and hemioxonol dyes. Particularly valuable dyes are those belonging to the cyanine dyes, merocyanine dyes, complex merocyanine dyes.

The silver halide emulsions may contain the usual stabilizers e.g. homopolar or salt-like compounds of mercury with aromatic or heterocyclic rings such as mercaptotriazoles, simple mercury salts, sulphonium mercury double salts and other mercury compounds. Other suitable stabilizers are azaindenes, preferably tetra- or penta-azaindenes, especially those substituted with hydroxy or amino groups. Compounds of this kind have been described by BIRR in Z. Wiss. Photogr. Photophys. Photochem. 47, 2-27 (1952). Other suitable stabilizers are i.a. heterocyclic mercapto compounds e.g. phenylmercaptotetrazole, quaternary benzothiazole derivatives, and benzotriazole. Preferred compounds are mercapto substituted pyrimidine derivatives as disclosed in US-P 3,692,527.

The silver halide emulsions may contain pH controlling ingredients. Preferably the emulsion layer is coated at a pH value below the isoelectric point of the gelatin to improve the stability characteristics of the coated layer. Other ingredients such as antifogging agents, development accelerators, wetting agents, and hardening agents for gelatin may be present. The silver halide emulsion layer may comprise light-screening dyes that absorb scattering light and thus promote the image sharpness. Suitable light-absorbing dyes are described in i.a. US-P 4,092,168, US-P 4,311,787 and DE-P 2,453,217,

More details about the composition, preparation and coating of silver halide emulsions can be found in e.g. Product Licensing Index, Vol. 92, December 1971, publication 9232, p. 107-109.

The layer containing physical development nuclei is preferably free of hydrophilic binder but may comprise small amounts upto 30% by weight of the total weight of said layer of a hydrophilic colloid e.g. polyvinyl alcohol to improve the hydrophilicity of the surface. Preferred development nuclei for use in accordance with the present invention are sulphides of heavy metals e.g. sulphides of antimony, bismuth, cadmium, cobalt, lead, nickel, palladium, platinum, silver, and zinc. Especially suitable development nuclei in connection with the present invention are palladium sulphide nuclei. Other suitable development nuclei are heavy metal salts such as e.g. selenides, polyselenides, polysulphides, mercaptans, and tin (II) halides. Heavy metals, preferably silver, gold, platinum, palladium, and mercury can be used in colloidal form.

To gain most advantage from the present invention, in particular to further reduce the number of copies that need to be disposed of at start-up and/or to improve printing endurance, the image receiving layer preferably comprises physical development nuclei, most preferably Pds-nuclei, having a number average diameter of not more than 6 nm and wherein the number of nuclei having a diameter of more than 4.5 nm is less than 15 % of the number of nuclei comprised in the image receiving layer. Preferably, the number average diameter is less than 3.5 nm.

Further, the physical development nuclei are preferably used in combination with a hydrophilic polymeric binder having functional groups that yield affinity for the nuclei. Examples of suitable functional groups are (i) heterocyclic ring systems having at least a N, O or S atom, (ii) thioether, thiol and thioxo groups, (iii) amido and guanidino groups. Specific examples of functional groups are imidazoles, imidazolines, pyrazole, thiazolidine, thiazolidone, thiazolone, indazole, pyridine, triazine, benztriazole, tetrazole, etc....

These functional groups are preferably present in structural units of the polymeric binder that may amount from 1 to 20 mole % of the polymer. The hydrophilicity of the binder may be obtained from hydrophilic groups contained in the polymer such as hydroxy, carboxyl, sulphonyl, etc..... Specific examples of suitable polymers are disclosed in US 4 160 670 which is incorporated herein by reference.

Between the support and the silver halide emulsion layer there is preferably provided a base layer that preferably contains an anti-halation substance such as e.g. light-absorbing dyes absorbing the light used for image-wise exposure of the imaging element. As alternative finely divided carbon black can be used as an anti-halation substance. On the other hand, in order to gain sensitivity, light reflecting pigments, e.g. titaniumdioxide can be present in the base layer. Further this layer can contain hardening agents, matting agents, e.g. silica particles, and wetting agents. Suitable matting agents preferably have an average diameter of 2-10$\mu$m and more preferably between 2$\mu$m and 5$\mu$m. The matting agents are generally used in a total amount in the imaging element of 0.1g/m$^2$ to 2.5g/m$^2$. At least part of these matting agents and/or light reflection pigments may also be present in the silver halide emulsion layer the most part, preferably at least 80% by weight however preferably being present in said base-layer. As a further alternative the light reflecting pigments may be present in a separate layer provided between the antihalation layer and the photosensitive silver halide emulsion layer. Like the emulsion layer the base layer is coated preferably at a pH value below the isoelectric point of the gelatin in the base layer.

In a preferred embodiment in connection with the present invention a backing layer is provided at the non-light sensitive side of the support. This layer which can serve as anti-curl layer can contain i.a. matting agents e.g. silica particles, lubricants, antistatic agents, light absorbing dyes, opacifying agents, e.g. titanium oxide and the usual ingredients like hardeners and wetting agents. The backing layer can consist of one single layer or a multiple layer pack e. g. a double layer pack.

According to a preferred embodiment in connection with the present invention the roughness of the backing layer package is adjusted such that an arithmetical mean deviation of profile $R_a$ of more than 0.7 is obtained. $R_a$ being obtained in accordance with the following formula:

$$R_a = (1/m) \cdot \int_{0}^{m} |f(x)| \; dx \; (\mu m)$$
$$\text{with m being } 0.8$$

When the $R_a$-value of the back of the printing plate is less than 0.7 the number of copies that have to be disposed of at the start of the printing process will generally be larger. However, if $R_a$ is below 0.15 an improvement may be obtained when the back of the printing plate is at least partially wetted when mounting it on the printing cylinder.

The hydrophilic layers usually contain gelatin as hydrophilic colloid binder. Mixtures of different gelatins with different viscosities can be used to adjust the rheological properties of the layer. But instead of or together with gelatin, use can be made of one or more other natural and/or synthetic hydrophilic colloids, e.g. albumin, casein, zein, polyvinyl alcohol, alginic acids or salts thereof, cellulose derivatives such as carboxymethyl cellulose, modified gelatin, e.g. phthaloyl gelatin etc.

The hydrophilic layers of the photographic element, especially when the binder used is gelatin, can be hardened with appropriate hardening agents such as those of the epoxide type, those of the ethylenimine type, those of the vinylsulfone type e.g. 1,3-vinylsulphonyl-2-propanol, chromium salts e.g. chromium acetate and chromium alum, aldehydes e.g. formaldehyde, glyoxal, and glutaraldehyde, N-methylol compounds e.g. dimethylolurea and methyloldimethylhydantoin, dioxan derivatives e.g. 2,3-dihydroxy-dioxan, active vinyl compounds e.g. 1,3,5-triacryloyl-hexahydro-s-triazine, active halogen compounds e.g. 2,4-dichloro-6-hydroxy-s-triazine, and mucohalogenic acids e.g. mucochloric acid and mucophenoxychloric acid. These hardeners can be used alone or in combination. The binders can also be hardened with fast-reacting hardeners such as carbamoylpyridinium salts of the type, described in US 4,063,952.

The imaging element used according to the present invention may further comprise various kinds of surface-active agents in the photographic emulsion layer or in at least one other hydrophilic colloid layer. Suitable surface-active agents include non-ionic agents such as saponins, alkylene oxides e.g. polyethylene glycol, polyethylene glycol/polypropylene glycol condensation products, polyethylene glycol alkyl ethers or polyethylene glycol alkylaryl ethers, polyethylene glycol esters, polyethylene glycol sorbitan esters, polyalkylene glycol alkylamines or alkylamides, silicone-polyethylene oxide adducts, glycidol derivatives, fatty acid esters of polyhydric alcohols and alkyl esters of saccharides; anionic agents comprising an acid group such as a carboxy, sulpho, phospho, sulphuric or phosphoric ester group; ampholytic agents such as aminoacids, aminoalkyl sulphonic acids, aminoalkyl sulphates or phosphates, alkyl betaines, and amine-N-oxides; and cationic agents such as alkylamine salts, aliphatic, aromatic, or heterocyclic quaternary ammonium salts, aliphatic or heterocyclic ring-containing phosphonium or sulphonium salts. Preferably compounds containing perfluorinated alkyl groups are used. Such surface-active agents can be used for various purposes e.g. as coating aids, as compounds preventing electric charges, as compounds improving slidability, as compounds facilitating dispersive emulsification and as compounds preventing or reducing adhesion.

The imaging element of the present invention may further comprise various other additives such as e.g. compounds improving the dimensional stability of the photographic element, UV-absorbers, spacing agents and plasticizers.

Suitable additives for improving the dimensional stability of the photographic element are e.g. dispersions of a water-soluble or hardly soluble synthetic polymer e.g. polymers of alkyl (meth)acrylates, alkoxy(meth)acrylates, glycidyl (meth)acrylates, (meth)acrylamides, vinyl esters, acrylonitriles, olefins, and styrenes, or copolymers of the above with acrylic acids, methacrylic acids, Alpha-Beta-unsaturated dicarboxylic acids, hydroxyalkyl (meth)acrylates, sulphoalkyl (meth)acrylates, and styrene sulphonic acids.

According to the method of the present invention the above described imaging element is image-wise exposed and subsequently developed according to the DTR-process. The DTR mono-sheet imaging element in connection with the present invention is exposed in an apparatus according to its particular application, e.g. a conventional process camera containing a conventional light source or a high intensity short time exposure such as e.g. a laser containing device.

The alkaline processing liquid used for developing the imaging element in accordance with the method of the present invention preferably contains at least part of the silver halide solvent(s). Preferably the silver halide solvent is used in an amount between 0.01% by weight and 10% by weight and more preferably between 0.05% by weight and 8% by weight. Suitable silver halide solvents for use in connection with the present invention are e.g. 2-mercaptobenzoic acid, cyclic imides, oxazolidones, thiocyanates and thiosulfates. Further suitable silver halide solvents for use in connection with the present invention are described in EP-A-554584.

According to the present invention the alkaline processing liquid preferably also contains hydrophobizing agents for improving the hydrophobicity of the silver image obtained in the image receiving surface layer. The hydrophobizing agents used in connection with the present invention are compounds that are capable of reacting with silver or silver ions and that are hydrophobic i.e. insoluble in water or only slightly soluble in water. Generally these compounds contain a mercapto group or thiolate group and one or more hydrophobic substituents e.g. an alkyl group containing at least 3 carbon atoms. Examples of hydrophobizing agents for use in accordance with the present invention are e.g. those described in US-P 3,776,728, US-P 4,563,410 and EP-A-554584.

The alkaline processing liquid may also contain the developing agent(s) used in accordance with the present invention. In this case the alkaline processing liquid is called a developer. On the other hand some or all of the developing agent(s) may be present in one or more layers of the imaging element. When all of the developing agents are contained in the imaging element the alkaline processing liquid is called an activator or activating liquid.

Silver halide developing agents for use in accordance with the present invention are preferably of the p-dihydroxybenzene type, e.g. hydroquinone, methylhydroquinone or chlorohydroquinone, preferably in combination with an auxiliary developing agent being a 1-phenyl-3-pyrazolidinone-type developing agent and/or p-monomethylaminophenol. Particularly useful auxiliary developing agents are of the phenidone type e.g. 1-phenyl-3-pyrazolidinone, 1-phenyl-4-monomethyl-3-pyrazolidinone, and 1-phenyl-4,4-dimethyl-3-pyrazolidinone. However other developing agents can be used.

The alkaline processing liquid preferably also contains a preserving agent having antioxidation activity, e.g. sulphite ions provided e.g. by sodium or potassium sulphite. For example, the aqueous alkaline solution comprises sodium sulphite in an amount ranging from 0.15 to 1.0 mol/l. Further may be present a thickening agent, e.g. hydroxyethylcellulose and carboxymethylcellulose, fog inhibiting agents, e.g. potassium bromide, potassium iodide and a benzotriazole which is known to improve the printing endurance, calcium-sequestering compounds, anti-sludge agents, and hardeners including latent hardeners.

Development acceleration can be accomplished with the aid of various compounds to the alkaline processing liquid and/or one or more layers of the photographic element, preferably polyalkylene derivatives having a molecular weight of at least 400 such as those described in e.g. US-P 3,038,805 - 4,038,075 - 4,292,400 - 4,975,354.

Subsequent to the development in an alkaline processing liquid the surface of the printing plate is preferably neutralized using a neutralization liquid.

A neutralization liquid generally has a pH between 5 and 7. The neutralization liquid preferably contains a buffer e.g. a phosphate buffer, a citrate buffer or mixture thereof. The neutralization solution can further contain bactericides, e.g. phenol, thymol or 5-bromo-5-nitro-1,3-dioxan as described in EP 0,150,517. The liquid can also contain substances which influence the hydrophobic / hydrophilic balance of the printing plate obtained after processing of the DTR element, e.g. silica. Further the neutralization solution can contain wetting agents, preferably compounds containing perfluorinated alkyl groups.

The invention will now be illustrated by the following examples without however the intention to limit the invention thereto. All parts are by weight unless otherwise specified.

EXAMPLE 1

Preparation of the silver halide emulsion coating solution.

A silver chlorobromide emulsion composed of 98.2mol% of chloride and 1.8mol% of bromide was prepared by the double jet precipitation method. The average silver halide grain size was 0.4μm (diameter of a sphere with equivalent volume) and contained Rhodium ions as internal dopant. The emulsion was orthochromatically sensitized and stabilized by a 1-phenyl-5-mercapto-tetrazole.

Preparation of the imaging elements

3 biaxially oriented polyethylene terephthalate film supports having a thickness of 175μm and an E-modulus as set out in table 1 and being provided with a adhesion improving layer were each coated with a layer containing gelatin in an amount of 0.4g/m$^2$ and colloidal silica having an average particle diameter of 7nm in an amount of 0.4g/m$^2$. The adhesion improving layer contained a copolymer of itaconic acid (2%), vinylidene chloride (88%) and methylmethacrylate (10%).

An emulsion prepared as described above was coated to each of these coated polyethylene terephthalate film supports together with an anti-halation layer such that the amount of gelatin in the anti-halation layer was 2.7g/m$^2$ and 1.34g/m$^2$ for the silver halide emulsion layer. The amount of silver halide expressed as $AgNO_3$ was 1.25g/m$^2$ and the emulsion layer further contained developing agents and 120mg/m$^2$ of formaldehyde as a hardener. The anti-halation layer further contained a silica matting agent having an average particle size of 3.4μm and carbon black as anti-halation means.

The thus obtained elements were kept at 57 °C at a relative humidity of 34% for 1 day.

To the thus obtained elements was then coated a surface layer of PdS nuclei serving as physical development nuclei. This surface layer also contained 0.4g/m$^2$ of hydroquinone and 70mg of formaldehyde. The material was then stored for 1 day at 57°C at a relative humidity of 34%.

The following alkaline processing solution was prepared:

| | |
|---|---|
| sodium hydroxide (g) | 30 |
| sodium sulphite anh. (g) | 33 |
| potassium thiocyanate (g) | 20 |
| 3-mercapto-4-acetamido-5-n.heptyl-1,2,4-triazole (g) | 0.15 |
| water to make | 1 l |

The following neutralization solution was prepared:

| | |
|---|---|
| citric acid | 10 g |
| sodium citrate | 35 g |
| sodium sulphite anh. | 5 g |
| phenol | 50 mg |
| water to make | 1 l |

The following dampening liquid was prepared:

| | |
|---|---|
| water | 880 ml |
| citric acid | 6g |

(continued)

| boric acid | 8.4g |
|---|---|
| sodium sulphate anh. | 25g |
| ethyleneglycol | 100g |
| colloidal silica | 28g |

The above described imaging elements were image-wise exposed and processed at 30°C with the above described alkaline processing solution, subsequently neutralized at 25 °C with the neutralization solution described above and dried.

The printing plates thus prepared were mounted on an offset printing machine (two color GTO printing machine) such that the direction to which the E-modulus in table 1 corresponds was perpendicular to the axis of the printing cylinder. The printing press was equipped with a clamp system for mounting the plates. The inks used were commonly employed inks. As a blue ink K+E 4F 473 and as a black ink K+E 125 each available from BASF, were used. During the printing run the described dampening solution was used. The number of copies that had to be disposed of before a steady print could be obtained was evaluated. The results are listed in the following table:

Table 1

| Sample no. | E-modulus (N/mm$^2$) | Number of copies that had to be disposed of |
|---|---|---|
| 1 | 4230 | 200 |
| 2* | 4760 | 100 |
| 3 | 5350 | 75 |

(*) the polyethylene terephthalate film was isotropic and the obtained results were substantially the same irrespective of the way the plate was mounted.

## Claims

1. An imaging element comprising on a support in the order given a photosensitive layer comprising a silver halide emulsion and an image-receiving layer comprising physical development nuclei characterised in that said support is a polyethylene terephthalate film having a thickness between 0.1mm and 0.35mm and a Young modulus of at least 4300 N/mm$^2$.

2. An imaging element according to claim 1 wherein said polyethylene terephthalate film support has a Young modulus of at least 4500 N/mm$^2$.

3. An imaging element according to claim 1 or 2 wherein the ratio of the Young modulus in the longitudinal direction to the Young modulus in the transverse direction is between 0.8 and 1.3.

4. An imaging element according to any of the above claims wherein the side of the support opposite to the side containing the photosensitive layer is provided with one or more backing layers and wherein the surface of said backing layers has an arithmetical mean deviation of profile $R_a$ of at least 0.7 or not more than 0.15.

5. An imaging element according to any of the above claims wherein said polyethylene terephthalate film is a biaxially oriented.

6. An imaging element according to any of the above claims wherein said physical development nuclei have a number average diameter not more than 6 nm and wherein the number of physical development nuclei comprised in said image receiving layer and having a diameter of more than 4.5 nm is less than 15 % of the total number of physical development nuclei comprised in said image receiving layer.

7. A method for making a lithographic printing plate comprising the steps of image-wise exposing an imaging element as defined in any of the above claims and subsequently developing a thus obtained image-wise exposed imaging element by means of an alkaline processing solution in the presence of a silver halide solvent and developing agent.

8. A method for mounting a lithographic printing plate obtained according to the method of claim 7 wherein said lithographic printing plate is mounted on a printing cylinder of a printing press such that a direction of the support having a Young modulus of at least 4300N/mm$^2$ is perpendicular to the axis of said plate cylinder.

**Patentansprüche**

1. Ein Bildaufzeichnungselement, das auf einem Träger der angegebenen Reihe nach eine fotoempfindliche Silberhalogenidemulsionsschicht und eine Bildempfangsschicht mit physikalischen Entwicklungskeimen enthält, dadurch gekennzeichnet, daß der Träger ein Polyethylenterephthalatfilm mit einer Stärke zwischen 0,1 mm und 0,35 mm und einem Elastizitätsmodul von wenigstens 4.300 N/mm$^2$ ist.

2. Ein Bildaufzeichnungselement nach Anspruch 1, dadurch gekennzeichnet, daß der Polyethylenterephthalatfilmträger einen Elastizitätsmodul von wenigstens 4.500 N/mm$^2$ hat.

3. Ein Bildaufzeichnungselement nach Anspruch 1 oder 2, dadurch gekennzeichnet, daß das Verhältnis des Elastizitätsmoduls in Längsrichtung zum Elastizitätsmodul in Querrichtung zwischen 0,8 und 1,3 liegt.

4. Ein Bildaufzeichnungselement nach irgendeinem der vorstehenden Ansprüche, dadurch gekennzeichnet, daß die Seite des Trägers, die der Seite mit der fotoempfindlichen Schicht gegenüberliegt, mit einer oder mehreren Rückschichten versehen ist, wobei die Oberfläche der Rückschichten eine arithmetische Mittelabweichung vom Profil $R_a$ zwischen 0,7 und 0,15 hat.

5. Ein Bildaufzeichnungselement nach irgendeinem der vorstehenden Ansprüche, dadurch gekennzeichnet, daß der Polyethylenterephthalatfilm biaxial orientiert ist.

6. Ein Bildaufzeichnungselement nach irgendeinem der vorstehenden Ansprüche, dadurch gekennzeichnet, daß die physikalischen Entwicklungskeime einen zahlendurchschnittlichen Durchmesser von nicht mehr als 6 nm aufweisen, wobei die Anzahl der in der Bildempfangsschicht enthaltenen physikalischen Entwicklungskeime mit einem Durchmesser von mehr als 4,5 nm kleiner ist als 15% der Gesamtanzahl der in der Bildempfangsschicht enthaltenen physikalischen Entwicklungskeime.

7. Ein Verfahren zur Herstellung einer lithografischen Druckform, das die folgenden Stufen umfaßt : die bildmäßige Belichtung eines wie in irgendeinem der vorstehenden Ansprüche definierten Bildaufzeichnungselements und danach die Entwicklung eines so erhaltenen bildmäßig belichteten Bildaufzeichnungselements mittels einer alkalischen Verarbeitungslösung in Gegenwart von einem Silberhalogenid-Lösungsmittel und einem Entwickler.

8. Ein Verfahren zur Montage einer nach dem Verfahren des Anspruchs 7 erhaltenen lithografischen Druckform, dadurch gekennzeichnet, daß die lithografische Druckform derart auf einen Druckzylinder einer Druckpresse montiert wird, daß die Richtung des Trägers mit einem Elastizitätsmodul von wenigstens 4.300 N/mm$^2$ senkrecht auf der Achse des Plattenzylinders steht.

**Revendications**

1. Un élément formant image contenant sur un support dans l'ordre indiqué une couche photosensible contenant une émulsion à l'halogénure d'argent et une couche réceptrice d'image contenant des germes de développement physique, caractérisé en ce que le support est un film de polyéthylène-téréphtalate ayant une épaisseur comprise entre 0,1 mm et 0,35 mm et un module de Young d'au moins 4.300 N/mm$^2$.

2. Un élément formant image selon la revendication 1, caractérisé en ce que le film de polyéthylène-téréphtalate a un module de Young d'au moins 4.500 N/mm$^2$.

3. Un élément formant image selon la revendication 1 ou 2, caractérisé en ce que le rapport du module de Young en sens longitudinal au module de Young en sens transversal est compris entre 0,8 et 1,3.

4. Un élément formant image selon l'une quelconque des revendications précédentes, caractérisé en ce que le côté du support opposé au côté contenant la couche photosensible est enduit d'une ou plusieurs couches dorsales et que la surface de ces couches dorsales présente une déviation arithmétique moyenne du profil $R_a$ comprise entre

EP 0 674 227 B1

0,7 et 0,15.

5. Un élément formant image selon l'une quelconque des revendications précédentes, caractérisé en ce que le film de polyéthylène-téréphtalate a une orientation biaxiale.

6. Un élément formant image selon l'une quelconque des revendications précédentes, caractérisé en ce que les germes de développement physique ont un diamètre moyen en nombre inférieur à 6 nm et que le nombre de germes de développement physique contenus dans la couche réceptrice d'image et ayant un diamètre supérieur à 4,5 nm est inférieur à 15% du nombre total de germes de développement physique compris dans la couche réceptrice d'image.

7. Une méthode pour la fabrication d'une plaque d'impression lithographique comprenant les étapes de l'exposition d'un élément formant image tel que défini dans l'une quelconque des revendications précédentes et ensuite le développement d'un élément formant image exposé sous forme d'image ainsi obtenu à l'aide d'une solution de traitement alcaline en présence d'un solvant des halogénures d'argent et d'un révélateur.

8. Un procédé pour le montage d'une plaque d'impression lithographique obtenue selon le procédé de la revendication 7, caractérisé en ce que la plaque d'impression lithographique est montée sur un rouleau d'impression d'une presse à imprimer de façon à ce qu'un sens du support ayant un module de Young d'au moins 4.300 N/mm$^2$ soit perpendiculaire à l'axe du rouleau d'impression.